# EUROPÄISCHE PATENTSCHRIFT

(11) **EP 1 092 787 B1**
(45) Veröffentlichungstag und Bekanntmachung des Hinweises auf die Patenterteilung: **15.08.2007**
(21) Anmeldenummer: 00121653.0
(22) Anmeldetag: 04.10.2000
(51) Int. Cl.: C23C 14/02, C23C 14/06, G02B 1/10

(54) **Verfahren zum Beschichten von Kunststoff-Oberflächen unter Vakuum**
Process for coating plastic surfaces in a vacuum
Procédé de revêtement sous vide des surfaces plastiques

(30) Priorität: 14.10.1999 CH 187799
(43) Veröffentlichungstag der Anmeldung: 18.04.2001
(73) Patentinhaber: Satisloh AG, 6340 Baar (CH)
(72) Erfinder: Siegrist, Beat, 8704 Herrliberg (CH)
(74) Vertreter: Oppermann, Mark

(56) Entgegenhaltungen:
- WO-A-97/32718
- DE-A1- 19 859 695
- DE-B- 1 002 584
- US-A- 4 537 814
- US-A- 4 963 012

## Beschreibung

Die vorliegende Erfindung betrifft ein Verfahren zum Beschichten von Kunststoff-Oberflächen unter Vakuum, insbesondere zum Beschichten von optischen Substraten aus Kunststoff, wie Brillengläser, in einem gasdicht verschliessbaren, evakuierbaren und mit einer Atmosphäre aus inertem Gas versehbaren Rezipienten mit Mitteln zum Aufbringen von Vergütungs- resp. Funktionsschichten, wie Schichten mit reversiblen photochromischen Eigenschaften o. dgl., auf die Kunststoff-Oberflächen.

In der Vakuum-Beschichtungstechnik werden dünne Schichten vermehrt auf Kunststoff-Oberflächen aufgebracht.

Hierbei können die Mittel zum Aufbringen solcher Schichten in einem gasdicht verschliessbaren, evakuierbaren und mit einer Atmosphäre aus inertem Gas versehbaren Rezipienten Elektronenstrahlverdampfer, thermische Verdampfer, Sputterkathoden oder dergleichen sein. Anlagen dieser Art sind bekannt. Inerte Gase können dabei in bekannter Weise Arbeitsgase, wie Argon oder Krypton, oder Reaktionsgase, wie Sauerstoff oder Stickstoff, sein.

Die aufgebrachten Schichten haben dabei vielfältige Funktionen, beispielsweise in der Optik als Reflexionsverminderungsschichten, Schichten mit reversiblen photochromischen Eigenschaften, Verspiegelungen, optische Filter, u.a. oder in der Elektronik als elektrische Leiterbahnen, Widerstandsschichten, u.a.

Die grössten Qualitätsprobleme derartiger Beschichtungen bilden allerdings deren mangelnde Haftfestigkeit auf der Kunststoff-Unterlage. Nicht selten zeigen die Beläge Ablöseerscheinungen oder weisen eine nur schwache Bindung mit dem Substrat auf.

WO 97/32718 offenbart ein Verfahren zum Beschichten Von Kunststoff-Oberflächen, wobei eine Adhäsionschicht aus einem anorganischen Material (z.B. SiO) zwischen den Kunststoff und der Beschichtung vorliegt.

Aufgabe der vorliegenden Erfindung ist nun die Schaffung eines Verfahrens der vorgenannten Art, mit dem sich die Haftfestigkeit solcher Vergütungs- resp. Funktionsschichten auf Kunststoff-Oberflächen ganz bedeutend verbessern lässt.

Dies wird erfindungsgemäss dadurch erreicht, dass vor dem Aufdampfen der Vergütungs- resp. Funktionsschichten eine Adhäsionsschicht auf die Kunststoff-Oberflächen aufgebracht wird, wobei zur Bildung der Adhäsionsschicht von einem Silizium - Target Silizium (Si) in Gegenwart des Reaktivgases Stickstoff (N₂) auf die Kunststoff-Oberflächen aufgebracht wird.

Hierbei wurde gefunden, dass beim Aufbringen einer Silizium (Si) - Schicht auf eine Kunststoff-Oberfäche ohne die Zufuhr von Stickstoff sich reine Silizium-Filme bilden, die bereits ab geringer Dicke opak, d.h. für das Auge nicht durchsichtig sind. Das Einfliessenlassen von Stickstoff ruft dagegen bei der aufwachsenden Schicht Si-N-Verbindungen hervor und lässt die Beschichtung optisch transparent werden. Bekannt ist aber auch, dass freie Silizium-Schichtanteile mit dem Sauerstoff der Kunststoff-Oberflächen eine Oxydation eingehen. In dieser Korrelation liegt die Bedeutung der erfindungsgemässen Adhäsions-Verstärkung.

Vorzugsweise wird beim erfindungsgemässen Verfahren zudem, je nach verwendeter Anlage und verwendeter Mittel zum Aufbringen solcher Schichten, das zugeführte Stickstoffgas (N₂) bis zu einem Grenzbereich derart dosiert und erhöht, bis die Adhäsionsschicht gerade farblos, d.h. von Auge in der Durchsicht glasklar erscheint, m. a. W. also keinerlei Absorption im sichtbaren Spektralbereich aufweist.

Hierbei ist es zweckmässig, wenn die Adhäsionsschicht mittels Sputterkathode aufgebracht wird.

Nach dem Aufbringen der in der Regel sehr dünnen, beispielsweise nur wenige Nanometer betragende Adhäsionsschicht auf die Kunststoff-Oberflächen werden auf dieser Adhäsionsschicht die Vergütungs- resp. Funktionsschichten (optische oder elektrische, einfache oder mehrfache) unterschiedlichster Materialien und mit beliebiger Beschichtungstechnik in bekannter Weise aufgetragen.

Es wird Schutz beansprucht wie folgt:

## Patentansprüche

1. Verfahren zum Beschichten von Kunststoff-Oberflächen unter Vakuum, insbesondere zum Beschichten von optischen Substraten aus Kunststoff, wie Brillengläser, in einem gasdicht verschliessbaren, evakuierbaren und mit einer Atmosphäre aus inertem Gas versehbaren Rezipienten mit Mitteln zum Aufbringen von Vergütungs- resp. Funktionsschichten, wie Schichten mit reversiblen photochromischen Eigenschaften o. dgl., auf die Kunststoff-Oberflächen, wobei
vor dem Aufdampfen der Vergütungs- resp. Funktionsschichten eine Adhäsionsschicht auf die Kunststoff-Oberflächen aufgebracht wird, **dadurch gekennzeichnet,dass** zur Bildung der Adhäsionsschicht von einem Silizium - Target Silizium (Si) in Gegenwart des Reaktivgases Stickstoff (N₂) auf die Kunststoff-Oberflächen aufgebracht wird.

2. Verfahren nach Anspruch 1, **dadurch gekennzeichnet, dass** die Adhäsionsschicht mittels Sputterkathode aufgebracht wird.

3. Verfahren nach Anspruch 1, **dadurch gekennzeichnet, dass** das zugeführte Stickstoffgas (N₂) bis zu einem Grenzbereich dosiert wird, in welchem die Adhäsionsschicht gerade farblos, d.h. von Auge in der Durchsicht glasklar erscheint, also keinerlei Absorption im sichtbaren Spektralbereich aufweist.

4. Verfahren nach Anspruch 1, **dadurch gekennzeichnet, dass** nach dem Aufbringen der Adhäsionsschicht auf die Kunststoff-Oberflächen auf dieser Adhäsionsschicht die Vergütungs- resp. Funktionsschichten mit beliebiger Beschichtungstechnik aufgebracht werden.

## Claims

1. Process for coating plastic surfaces under a vacuum, in particular for coating optical substrates comprised of plastic, such as spectacle lenses, in a container that can be sealed gas tight, evacuated and provided with an atmosphere comprised of inert gas, with means for applying blooming or functional layers, such as layers with reversible photochromic properties or the like, on the plastic surfaces, wherein an adhesive layer is applied to the plastic surfaces prior to the vacuum evaporation of the blooming or functional layers, **characterized in that** silicon (Si) is applied to the plastic surfaces from a silicon target in the presence of the reaction gas nitrogen (N₂) to form the adhesive layer.

2. Process according to claim 1, **characterized in that** the adhesive layer is applied using a sputter cathode.

3. Process according to claim 1, **characterized in that** the supplied nitrogen gas (N₂) is metered in to a limit at which the adhesive layer has just turned colorless, i.e., appears clear as glass to the naked eye, in other words, exhibits no absorption in the visible spectral range.

4. Process according to claim 1, **characterized in that**, after the application of the adhesive layer to the plastic surfaces, the blooming or functional layers are applied to this adhesive layer using any coating technique desired.

## Revendications

1. Procédé de revêtement sous vide de surfaces en matière plastique, notamment de revêtements de substrats optiques en matière plastique, tels que des verres à lunettes, dans un récipient susceptible d'être fermé de façon étanche au gaz et d'être évacué et susceptible d'être doté d'une atmosphère sous gaz inerte, avec des moyens d'application de couches antireflet, respectivement de couches fonctionnelles, telles que des couches avec des caractéristiques photochromiques réversibles ou similaires sur les surfaces en matière plastique, avant la vaporisation des couches antireflet, respectivement des couches fonctionnelles, une couche d'adhésion étant appliquée sur les couches en matière plastique, **caractérisé en ce que**, pour la formation de la couche d'adhésion du silicium (Si) d'un silicium cible, est appliqué sur les surfaces en matière plastique, en présence du gaz réactif, de l'azote (N₂).

2. Procédé selon la revendication 1, **caractérisé en ce que** la couche d'adhésion est appliquée au moyen d'une cathode de pulvérisation.

3. Procédé selon la revendication 1, **caractérisé en ce que** le gaz d'azote (N₂) alimenté est dosé et augmenté jusqu'à une plage limite, jusqu'à ce que la couche d'adhésion apparaisse sous forme incolore, c'est-à-dire limpide en transparence à l'oeil nu, en d'autres termes, qu'elle ne fasse preuve d'aucune absorption dans le domaine spectral visible.

4. Procédé selon la revendication 1, **caractérisé en ce que**, après l'application de la couche d'adhésion sur les surfaces en matière plastique, les couches antireflet, respectivement les couches fonctionnelles sont appliquées sur cette couche d'adhésion avec une technique de revêtement quelconque.
